# EUROPÄISCHE PATENTANMELDUNG

(11) **EP 4 425 581 A1**
(43) Veröffentlichungstag der Anmeldung: **04.09.2024**
(21) Anmeldenummer: 24159110.6
(22) Anmeldetag: 22.02.2024
(51) Int. Cl.: H01L 31/12, G02B 6/12, H04B 10/43

(54) **OPTOELEKTRONISCHE SENDEVORRICHTUNG, EMPFANGSVORRICHTUNG UND SCHALTKREIS**

(30) Priorität: 02.03.2023 AT 501552023
(71) Anmelder: AIT Austrian Institute of Technology GmbH, 1210 Wien (AT)
(72) Erfinder: SCHRENK, Bernhard Dr., 2122 Ulrichskirchen (AT); HÜBEL, Hannes Dr., 1180 Wien (AT)
(74) Vertreter: Wildhack & Jellinek Patentanwälte

(57) **Zusammenfassung**

Die Erfindung betrifft eine auf einem Silizium-Chip integrierbare optoelektronische Sendevorrichtung (T1), umfassend
a) einen elektronischen Eingang (TX),
b) einen optischen Wellenleiter-Anschluss (O) zur Abgabe von optischen Signalen,
c) eine Diode (D) in Form einer wellenleitergebundenen Silizium-Germanium pin-Photodiode mit zwei Elektroden (A, K), wobei der der optische Wellenleiter-Anschluss (O) am photosensitiven Bereich der Diode (D) mündet, und
d) einen dem elektronischen Eingang (TX) nachgeschalteten Datentreiber (DRV), der dazu ausgebildet ist, am elektronischen Eingang (TX) anliegende elektronische Signale in Form von elektrischen Strom- und/oder Spannungssignalen an der Diode (D) anzulegen, sodass sich abhängig von dem am Dateneingang (TX) anliegenden Signal ein Stromfluss in Durchlassrichtung der Diode (D) ausbildet, sodass die Diode daraufhin über ihren photosensitiven Bereich elektromagnetische Wellen über den Wellenleiter-Anschluss (O) abgibt.

## Beschreibung

Die Erfindung betrifft eine optoelektronische Sendevorrichtung nach Anspruch 1, eine optoelektronische Sende- und Empfangsvorrichtung nach Anspruch 2 sowie einen optoelektronischen Schaltkreis nach Anspruch 3 oder 4.

Aus dem Stand der Technik sind Lichtemitter basierend auf III-V Materialien bekannt. Diese sind auch effizient, d.h. das Verhältnis von emittierter Lichtleistung zu injiziertem elektrischem Strom ist sehr gut. Zudem kann die Wellenlänge durch das Design gewählt werden. Der Bereich deckt sowohl den sichtbaren Wellenlängenbereich als auch das nahe Infrarot (Telekom-Fenster um die 1550 nm) gut ab.

Soll nun ein solcher III-V Lichtemitter (z.B. basierend auf InP, InGaAs), der auf einem Halbleitermaterial mit direktem Bandgap beruht, mit kostengünstigen Silizium-basierten Modulatoren, Detektoren bzw. anderen (wellenleitergebundenen) Elementen zur Signalmanipulation kombiniert werden, so ist dies mit einem enormen Aufwand in Bezug auf Hetero-Integration sowie auch in Bezug auf Assembly und Packaging verbunden, was die Kosten einer derart hybriden Komponente signifikant steigert. Eine monolithisch integrierte Komponente auf Silizium-Basis (Gruppe IV im Periodensystem) würde diesbezüglich einen klaren Vorteil bringen, es wären beispielsweise weniger Interfaces zwischen Chips erforderlich, da nur ein Chip notwendig wäre und damit auch das Alignment zwischen optischen Wellenleitern unterschiedlicher Chips entfiele, um eine gute optische Kopplung zu erreichen. Ebenso können die Kosten für das Packaging entfallen, da Silizium-basierte Elemente nicht zwingend hermetisch versiegelt werden müssen, um deren Lebensdauer zu garantieren.

Silizium als Halbleitermaterial eignet sich dagegen weniger gut für die Herstellung von Lichtemittern, da es ein indirektes Bandgap aufweist, was die Effizienz der Lichtemission stark, dh um mehrere Zehnerpotenzen im Vergleich mit direkten Halbleitern reduziert. Ein Ansatz, der bekannt ist, um Silizium-Leuchtdioden zu realisieren, ist die Verwendung von Germanium - einem Material, welches mit Silizium-Integrationsplattformen kompatibel ist. Germanium hat ein pseudo-direktes Bandgap, dessen direktes Minimum im Banddiagramm ("Γ Valley") energetisch gesehen nur knapp über dem indirekten Minimum ("L Valley") liegt. Die Bandstruktur eines Halbleiters korreliert mit der Gitterkonstante, welche durch Verspannung modifiziert werden kann. Durch eine solche Verspannung im Halbleiter ("tensile stress") kann dieser Unterschied im Minimum des Banddiagramms verringert werden, wodurch sich die Emissionseffizienz erhöht. Diese Germanium-LEDs wurden in Hinsicht auf im Vergleich zu rein Silizium-basierten LEDs auf ihre erhöhte Effizienz im Telekom-Fenster gezeigt. Allerdings handelt es sich bei diesen Germanium-LEDs um sehr spezielle und aufwendig zu fertigende Bauelemente, die rein auf Lichtemission ausgelegt sind.

Im Zuge der gegenständlichen Erfindung werden hingegen Silizium-Germanium Photodioden eingesetzt, um diese Lichtemission bei Raumtemperatur zu erzielen und auch zwischen mehreren Betriebsmodi zu wechseln. Zur Verwendung der Photodiode als Lichtemitter wird diese in Vorwärtsrichtung betrieben.

Aufgabe der Erfindung ist es, eine Sendevorrichtung zur Verfügung zu stellen, mit die unmittelbar in einem Silizium-Chip integriert werden kann. Die Erfindung löst diese Aufgabe bei einer optoelektronischen Sendevorrichtung, die zumindest die folgenden Bestandeile aufweist:
a) einen elektronischen Eingang,
b) einen optischen Wellenleiter-Anschluss zur Abgabe von optischen Signalen,
c) eine Diode in Form einer wellenleitergebundenen Silizium-Germanium pin-Photodiode mit zwei Elektroden, wobei der der optische Wellenleiter-Anschluss am photosensitiven Bereich der Diode mündet, und
d) einen dem elektronischen Eingang nachgeschalteten Datentreiber, der dazu ausgebildet ist, am elektronischen Eingang anliegende elektronische Signale in Form von elektrischen Strom- und/oder Spannungssignalen an der Diode anzulegen, sodass sich abhängig von dem am Dateneingang anliegenden Signal ein Stromfluss in Durchlassrichtung der Diode ausbildet, sodass die Diode daraufhin über ihren photosensitiven Bereich elektromagnetische Wellen über den Wellenleiter-Anschluss abgibt.

Aufgabe der Erfindung ist es ebenso, eine Sende- und Empfangsvorrichtung zur Verfügung zu stellen, mit die unmittelbar in einem Silizium-Chip integriert werden kann. Die Erfindung löst diese Aufgabe bei einer optoelektronischen Sende- und Empfangsvorrichtung, die zumindest die folgenden Bestandteile umfasst:
a) einen optischen Wellenleiter-Anschluss, über welchen optische Signale bidirektional von und zu der optoelektronischen Sende- und Empfangsvorrichtung gelangen,
b) einen elektronischen Dateneingang,
c) einen elektronischen Datenausgang,
d) einen Steuereingang zur Auswahl eines Betriebsmodus, an dem ein Steuersignal anliegt, das vorgibt, ob sich die Sende- und Empfangsvorrichtung im jeweiligen Zeitpunkt entweder
   - in einem Sendemodus befindet und optischen Datensignale am optischen Wellenleiter-Anschluss als am elektronischen Dateneingang anliegenden elektronischen Daten aussendet, oder
   - in einem Empfangsmodus befindet und optische Datensignale über den optischen Wellenleiter-Anschluss empfängt und in ein am Datenausgang anliegendes elektronisches Datensignal umwandelt,
e) eine Diode in Form einer wellenleitergebundenen Silizium-Germanium pin-Photodiode mit zwei Elektroden, wobei der der optische Wellenleiter-Anschluss am photosensitiven Bereich der Diode mündet,
f) einen dem Steuereingang und dem elektronischen Dateneingang nachgeschalteten Datentreiber, der an die Kathode der Diode angeschlossen ist und dazu ausgebildet ist,
   - während des Sendemodus am elektronischen Dateneingang anliegende Signale in Form von elektrischen Spannungssignalen an der Diode anzulegen, sodass sich abhängig von dem am Dateneingang anliegenden Signal ein Stromfluss in Durchlassrichtung der Diode ausbildet,
      und
   - während des Empfangsmodus die Kathode der Diode auf einen vorgegebenen Spannungsniveau oder Arbeitspunkt vorzuspannen, sodass sich bei Vorliegen eines optischen Signals am photosensitiven Bereich der Diode ein vom optischen Signal abhängiger Photostrom in Sperrrichtung der Diode ausbildet,
g) einen Verstärker, insbesondere einen Transimpedanzverstärker, der an die Anode der Diode angeschlossen ist und dazu ausgebildet ist,
   - während des Sendemodus die Anode der Diode auf einen vorgegebenen Spannungsniveau oder Arbeitspunkt vorzuspannen,
   - während des Empfangsmodus, den durch die Diode fließenden Diodenstrom zu messen, in ein elektrisches Signal umzuwandeln und derart am elektronischen Datenausgang zur Verfügung zu stellen.

Die Erfindung betrifft auch einen optoelektronischen integrierten silizium-basierten Schaltkreis, in den einer erfindungsgemäße Sendevorrichtung und/oder eine Sende- und Empfangsvorrichtung integriert ist. Dieser umfasst zumindest eine erfindungsgemäße optoelektronische Sendevorrichtung und/oder eine erfindungsgemäße optoelektronische Sende- und Empfangsvorrichtung, insbesondere eine Mehrzahl solcher Vorrichtungen, der oder die auf oder in demselben Trägermaterial integriert sind,
- eine elektrische Steuereinheit zum Ansteuern der zumindest einen optoelektronischen Sende- und/oder Empfangsvorrichtungen, die im silizium-basierter Schaltkreis integriert ist,
- ein im selben Schaltkreis integriertes optisches Netzwerk umfassend zumindest einen externen optischen Wellenleiter-Anschluss, und eine Anzahl von Wellenleitern, die an die optischen Wellenleiter-Anschlüsse der zumindest einen Sende- und/oder Empfangsvorrichtung und an den zumindest einen externen optischen Wellenleiter-Anschluss angeschlossen sind.

Die Erstellung von optischen Signalen kann dadurch verbessert werden, dass die Steuereinheit dazu ausgebildet ist, die optoelektronischen Sende- und/oder Empfangsvorrichtungen und gegebenenfalls im optischen Netzwerk befindliche elektrooptische Bauelemente derart anzusteuern, dass am Wellenleiter-Anschluss das festgelegte abzugebende Signal anliegt.

Eine Sendevorrichtung, bei der ein Sendesignal von außen vorgegeben werden kann, kann dabei implementiert werden, indem zumindest ein elektronischen Dateneingang vorgesehen wird, der an die elektrische Steuereinheit angeschlossen ist und zumindest ein vom Schaltkreis an seinem zumindest einen Wellenleiter-Anschluss abzugebendes Signal festlegt.

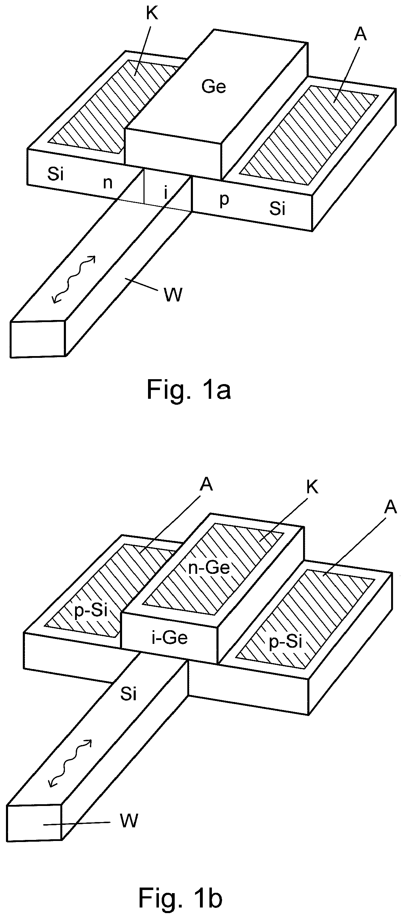

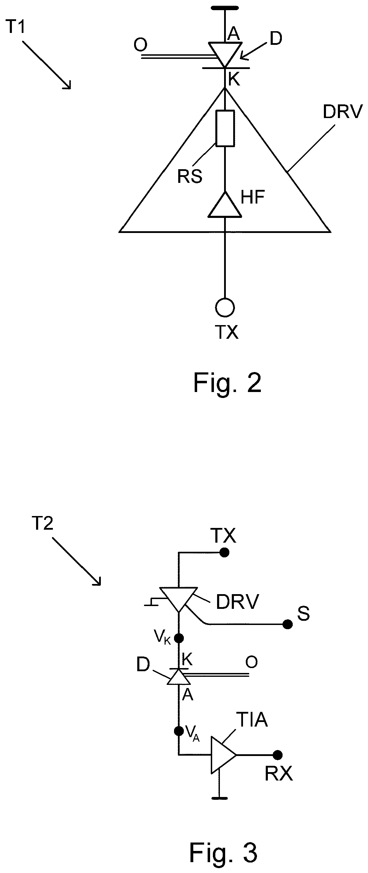

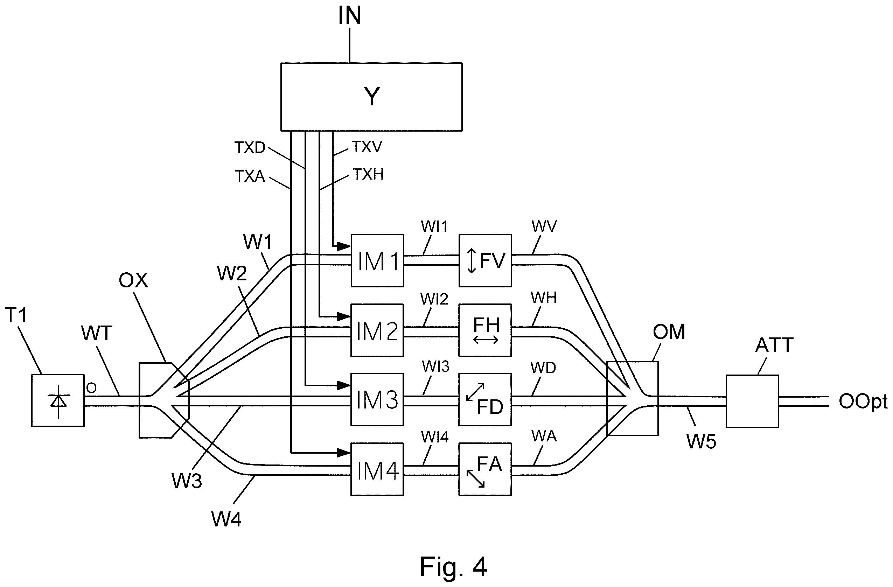

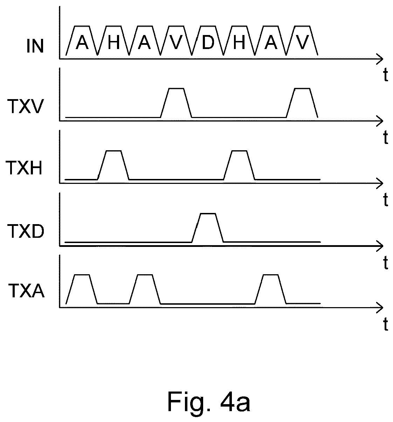

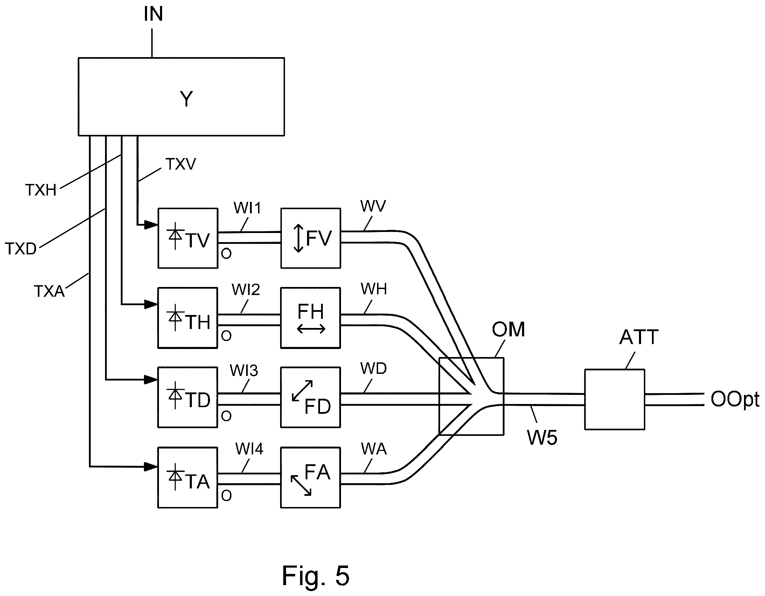

Einzelne Ausführungsformen der Erfindung werden anhand der folgenden Zeichnungsfiguren näher beschrieben. In **Fig. 1a** und **1b** sind einige bekannte Ausführungsformen mit typischen Strukturen von wellenleitergebundenen Silizium-Germanium pin-Photodioden näher dargestellt. **Fig. 2** zeigt eine Schaltung mit einer Sendevorrichtung entsprechend einer ersten Ausführungsform der Erfindung. **Fig. 3** zeigt eine Schaltung mit einer Sende- und Empfangsvorrichtung entsprechend einer ersten Ausführungsform der Erfindung. **Fig. 4** und **5** zeigen die Vorteile der Erfindung Hinblick auf die Integration erfindungsgemäßer Sendevorrichtungen und Sende- und Empfangsvorrichtungen in einem gemeinsamen Schaltkreis mit einem optischen Netzwerk. **Fig. 4a** zeigt eine mögliche Ansteuerung eines in **Fig. 4** dargestellten Schaltkreises mittels einer Steuereinheit.

Die In **Fig. 1a** und **1b** dargestellten bekannten Ausführungsformen zeigen mit typischen Strukturen von wellenleitergebundenen Silizium-Germanium pin-Photodioden. Diese sind im Stand der Technik bereits erprobt und zur Detektion von Licht unterschiedlicher Wellenlängen geeignet. Die Funktion und Herstellung solcher pin-Photodioden ist beispielsweise in Siew et al, Review of Silicon Photonics Technology and Platform Development, JOURNAL OF LIGHTWAVE TECHNOLOGY, VOL. 39, NO. 13, JULY 1, 2021, Seiten 4374-4389 näher beschrieben.

Die Parameter dieser Photodiode werden zweckmäßigerweise für den Dual-Betrieb (Emitter / Detektor) optimiert, z.B. die Dicke der intrinsischen i-Zone, welche im Fall einer weiteren i-Zone die Detektion von Lichtsignalen begünstigt, jedoch nicht die Lichtemission. Es wird sich daher, bezogen auf den exakten Aufbau der pin-Photodiode und die für die Herstellung verwendete Silizium-basierte Integrationsplattform, in der Regel ein optimaler Wert für die Breite der i-Zone ergeben.

Betreibt man die in den **Fig. 1a** und **1b** dargestellten pin-Photodioden in Vorwärtsrichtung, liefern diese an ihrem optischen Ausgang einen konstanten Licht-Output mit einer relativ breiten spektralen Charakteristik, ähnlich einer Leuchtdiode. Allerdings ist die Lichtleistung wesentlich geringer und beträgt typischerweise 100 pW bei einem Durchlassstrom von 40 mA. Das Halbleitermaterial kann durch bekannte Methoden so gestaltet sein, dass ein spezieller Wellenlängenbereich adressiert wird, wie etwa das Telekom Fenster mit C + L Band mit einer Wellenlänge zwischen 1530 bis 1625 nm - für beide Betriebsarten, dh sowohl für Lichtemission als auch für Lichtdetektion.

**Fig. 2** zeigt eine Schaltung mit einer Sendevorrichtung T1 entsprechend einer ersten Ausführungsform der Erfindung. Diese Sendevorrichtung verfügt über eine wellenleitergebundene Silizium-Germanium pin-Photodiode D und weist einen elektronischen Eingang TX zum Aktivieren der Sendevorrichtung T1 auf. Sofern die Sendevorrichtung T1 dauerhaft Licht abgeben soll, kann der elektronischen Eingang TX gleichsam als Schaltereingang verwendet werden.

Eine Anwendung der Sendevorrichtung T1 kann darin bestehen, die Photodiode D zur Abgabe eines optischen Signals mit konstanter Leistung zu veranlassen. Es kann ebenso zum Zweck der Datenübertragung an einen geeigneten empfindlichen Empfänger moduliert werden, insbesondere in seiner Lichtintensität. So besteht auch die Möglichkeit, den elektronischen Eingang TX als Signaleingang zu verwenden, an dem ein zu übertragendes Signal anliegt, das von der Sendevorrichtung T1 abzugeben ist.

Das Signal des elektronischen Eingangs TX wird dabei an einen Treiber DRV weitergeleitet, der dazu ausgebildet ist, das elektronische Eingangssignal am Eingang TX in ein elektronisches Signal umzuwandeln, das die Photodiode D zur Abgabe von Licht mit einem vorgegebenen Signalverlauf veranlasst. Der Datentreiber DRV wandelt am elektronischen Eingang TX anliegende elektronische Signale in Form von elektrischen Strom- und/oder Spannungssignalen an der Photodiode D um, sodass sich abhängig von dem am Dateneingang TX anliegenden Signal ein Stromfluss in Durchlassrichtung der Photodiode D ausbildet, sodass die Photodiode D daraufhin über ihren photosensitiven Bereich elektromagnetische Wellen über den Wellenleiter-Anschluss O abgibt.

Im vorliegenden Ausführungsbeispiel steuert der Datentreiber DRV die Spannung an der Kathode K der Photodiode D an, während die Anode A der Photodiode D auf Massepotential liegt. Typischerweise kann die Kathodenspannung auf Spannungswerte von zwischen -1Vbis -2V gesetzt werden, wodurch sich eine stetige Zunahme der Leistung des optischen Signals von 0 bis zu etwa 100 pW ergibt. Die Photodiode D wird dabei in Durchlassrichtung betrieben, die Anode A liegt auf einem Potential von etwa 0V. Es stellt sich daraufhin ein Stromfluss zwischen der Anode A und der Kathode K ein.

Für eine schnelle Modulation der Lichtemission kann die Impedanz der Diodenstrecke auch an die Impedanz der Zuleitung und der Treiberschaltung angepasst werden, um maximale Leistungsübertragung zwischen dem elektrischen Treibersignal und der daraus resultierenden optischen Modulation zu gewährleisten. Dies wird in der Regel eine Anpassung der niedrigen Diodenimpedanz an die typischerweise 50-Ohm ausgestalteten Hochfrequenz-Treiberstufen HF erfordern und kann im einfachsten Fall durch eine Erhöhung der Impedanz durch einen einfachen Serienwiderstand RS erfolgen. Zweckmäßigerweise setzt sich der vom Treiber abgegebene Vorwärts-Strom der Photodiode D dann aus einem Gleichanteil und einem Wechselanteil zusammen: Der Wechselanteil bestimmt den Hub der Lichtintensität während der Modulation; Der Gleichanteil definiert den Arbeitspunkt, um welchen diese Modulation der Lichtintensität stattfindet.

Betreibt man die Photodiode D wie vorstehend dargestellt, gibt diese das optische Signal in ihrem photosensitiven Bereich ab. Dieser ist wellenleitergebunden, sodass das optische Signal über den Wellenleiter-Anschluss der Photodiode D zur Verfügung steht. Dieser Wellenleiter-Anschluss der Photodiode D bildet den optischen Anschluss O der Sendevorrichtung, das hier vorliegende optische Signal das optische Ausgangssignal der Sendevorrichtung T1.

Da es sich bei der Photodiode um ein Element handelt, welches Licht empfangen und, wie vorstehend beschrieben, auch Licht emittierten kann, kann nun auch eine Ausführungsform der Erfindung erreicht werden, die beide Funktionen, dh Senden und Empfangen von Licht, kombiniert. Eine solche Ausführungsform der Erfindung ist in **Fig. 3** näher dargestellt. Diese zeigt eine optoelektronische Sende- und Empfangsvorrichtung T2, die - wie die in **Fig. 2** dargestellte Sendevorrichtung T1 einen elektronischen Dateneingang TX sowie einen optischen Wellenleiter-Anschluss O aufweist. Anders als bei der Sendevorrichtung T1 aus **Fig. 2** kann die in **Fig. 3** dargestellte optoelektronische Sende- und Empfangsvorrichtung T2 über den optischen Anschluss sowohl optische Signale empfangen als auch aussenden, der optische Wellenleiter-Anschluss O kann also bidirektional betrieben werden, wobei das empfangene optische Signal als elektrisches Signal an einem elektronischen Datenausgang RX zur Verfügung gestellt wird.

Wie die Sendevorrichtung T1 des ersten Ausführungsbeispiels der Erfindung weist die Sende- und Empfangsvorrichtung eine Diode D in Form einer wellenleitergebundenen Silizium-Germanium pin-Photodiode mit zwei Elektroden A, K auf. Ebenso mündet der optische Wellenleiter-Anschluss O am photosensitiven Bereich der Diode D.

Die Sende- und Empfangsvorrichtung T2 kann zu jedem Zeitpunkt einerseits in einem Empfangsmodus betrieben werden, in dem optischen Datensignale am optischen Wellenleiter-Anschluss O empfangen, in ein am Datenausgang RX anliegendes elektronisches Datensignal umgewandelt und als am elektronischen Dateneingang TX anliegenden elektronischen Daten zur Verfügung gestellt werden. Andererseits kann die Sende- und Empfangsvorrichtung T2 in einem Sendemodus betrieben werden, wobei sie optische Datensignale am optischen Wellenleiter-Anschluss O aussendet, die durch das am elektronischen Dateneingang TX anliegenden elektronischen Daten festgelegt werden.

Zur Festlegung, in welchem Betriebsmodus sich die die Sende- und Empfangsvorrichtung T2 befindet, wird ein elektrisches Steuersignal über einen Steuereingang S vorgegeben, das dem Datentreiber DRV zugeführt ist. Der Datentreiber der Sende- und Empfangsvorrichtung T2 steuert wie auch bei der Sendevorrichtung T1 die Spannung an der Kathode der Diode an. Sofern sich die Sende- und Empfangsvorrichtung T2 im Sendemodus befindet, verhält sich der Datentreiber wie der Datentreiber der Sendevorrichtung T1. Da, wie später noch dargestellt wird, die Anode A in der vorliegenden Sende- und Empfangsvorrichtung T2 etwa auf Massepotential liegt, kann die an der Photodiode D anliegende Spannung durch Vorgabe des Potentials der Kathode K erreicht werden. Um einen Strom in Durchlassrichtung der Diode zu erreichen, kann Potentials der Kathode K auf Werte von zwischen -1V und -2V gesetzt werden, sodass sich an der Photodiode D Ströme von etwa 40 mA einstellen und die Photodiode D an ihrem optischen Wellenleiter-Anschluss O ein optisches Signal von etwa 100 pW abgibt. Befinden sich die Sende- und Empfangsvorrichtung T2 und Datentreiber DRV aufgrund des Steuersignals am Steuereingang hingegen im Empfangsmodus, spannt der Datentreiber DRV die Kathodenspannung auf einen Spannungswert vor, bei dem die Photodiode D gesperrt ist. Dies kann beispielsweise bei einer Spannungsdifferenz von etwa 3V zwischen Kathode K und Anode A der Fall sein, dh die Kathodenspannung liegt in diesem Fall bei 3V. In diesem Zustand wird die Photodiode D als in dem für sie typischen Empfangsmodus betrieben, dh der durch die Photodiode D fließende Strom ist proportional zur Leistung des an ihrem photosensitiven Bereich über den Wellenleiter einfallenden optischen Signals.

Die Anode A der Photodiode D ist an einen Verstärker angeschlossen, der im vorliegenden Ausführungsbeispiel als Transimpedanzverstärkers TIA ausgebildet ist. Der Eingang des Transimpedanzverstärkers TIA liegt dabei auf virtuellem Massepotential, der Transimpedanzverstärker TIA liefert an seinem Ausgang ein Spannungssignal, das proportional zum Diodenstrom der Photodiode und damit proportional zu dem am optischen Wellenleiter-Anschluss O einfallenden Licht ist.

Auch wenn ein Transimpedanzverstärker TIA eine vorteilhafte Realisierung des allgemeinen erfinderischen Gedankens darstellt, ist seine Verwendung im Rahmen der Erfindung nicht zwingend. Vielmehr reicht es aus, dass der Datentreiber dazu ausgebildet ist, an der Diode je nach Betriebsmodus die vorstehend beschriebenen Spannungen anzulegen und im Empfangsmodus den Diodenstrom zu messen, in ein weiterverarbeitbares Signal umzuwandeln und am Datenausgang RX zur Verfügung zu halten.

Während des Empfangsmodus ist die Kathode K der Diode D auf ein vorgegebenes Spannungsniveau oder einen Arbeitspunkt vorzuspannen, sodass sich bei Vorliegen eines optischen Signals am photosensitiven Bereich der Diode D ein vom optischen Signal abhängiger Photostrom in Sperrrichtung der Diode D ausbildet und gleichzeitig die Diodenkapazität minimiert wird, was den Empfang hochfrequenter Signale begünstigt. Obwohl die optischen Leistungspegel zwischen Sende- und Empfangsmodus in Senderichtung, d.h. emittierte Leistung der wellenleitergekoppelten Silizium-Germanium pin-Photodiode, und Empfangsrichtung, d.h. empfangene Leistung, um einen akzeptablen Signalempfang zu gewährleisten, sich stark unterscheiden, ist die beschriebene Ausführungsform vor allem dann vorteilhaft, wenn eine Auslagerung von Komplexität bei den beteiligten Sende-/Empfangs-Subsystemen in einem optischen Übertragungskanal aus Kostengründen bevorzugt ist. So kann zum Beispiel die Lichtquelle durch einen Silizium-basierten Sender wesentlich kostengünstiger gestaltet werden, sodass diese Kostenreduktion den Einsatz von optischen Transceivern in kosten-sensitiven Anwendungen ermöglicht werden. In derartigen Anwendungsszenarien stehen viele kostengünstige Transceiver nahe dem Endnutzer, u.a. auch Maschinen, in baum- oder sternförmig ausgeprägten Netzwerken wenigen zentralisierten Sende-/Empfangseinheiten am anderen Kanalende gegenüber. Für diese zentralisierten Einheiten kann dann ein komplexerer Empfänger mit weitaus höherer Empfindlichkeit aufgrund eines Kosten-Sharings zwischen vielen Endnutzern gerechtfertigt werden. Solche Empfänger mit erhöhter Empfindlichkeit sind etwa Einzelphotonen-Detektoren oder Empfänger basierend auf Photomultiplier-Effekten.

Anhand der in **Fig. 4** dargestellten weiteren vorteilhafte Ausführungsform der Erfindung werden zusätzliche Vorteile der Erfindung im Hinblick auf die Integration einer vorstehend beschriebenen Sendevorrichtung T1 (**Fig. 2**) oder einer Sende- und Empfangsvorrichtung T2 (**Fig.** 3) in einem Chip in Form eines optoelektronischen integrierten silizium-basierten Schaltkreises. Während die gemeinsame Verwendung von III-V Lichtemittern, z.B. InP, InGaAs, einen enormen Aufwand in Bezug auf Hetero-Integration sowie auch in Bezug auf Assembly und Packaging erfordert, kann im vorliegenden Ausführungsbeispiel eine monolithisch integrierte Komponente auf Silizium-Basis verwendet werden. Dies bringt den Vorteil mit sich, dass weniger Interfaces zwischen mehreren Chips erforderlich sind und auch das Alignment zwischen optischen Wellenleitern unterschiedlicher Chips entfallen kann.

Im Ausführungsbeispiel der **Fig. 4** ist eine einzige Sendevorrichtung T1 vorgesehen, die der in Fig. 2 dargestellten Sendevorrichtung T1 entspricht und über ihren optischen Wellenleiter-Anschluss O Licht einer konstanten Intensität abgibt. An ihrem, nicht dargestellten elektronischen Dateneingang liegt ein, insbesondere konstantes unmoduliertes, elektrisches Signal an. Die Sendevorrichtung T1 befindet sich in einem unmodulierten continuous-wave Betrieb. Der Chip verfügt über einen optischen Interconnect, dh eine Vielzahl von im Chip integrierten optischen Wellenleitern, die den optischen Wellenleiter-Anschluss O der Sendevorrichtung T1 mit anderen optischen Komponenten verbinden. Im vorliegenden Fall wird das von der Sendevorrichtung T1 erstellte optische Signal über einen Wellenleiter WT in einer optischen Verteilereinheit OX, auch als Beam-Splitter bezeichnet, auf insgesamt vier Wellenleiter W1, W2, W3, W4 verteilt. Diese Wellenleiter W1, W2, W3, W4 führen die optischen Signale jeweils zu einem Intensitätsmodulator IM1, IM2, IM3, IM4. Ein solcher Intensitätsmodulator kann beispielsweise durch einen Mach-Zehnder-Modulator, einen Elektroabsorptions-Modulator oder einen Mikro-Ring Modulator ausgebildet sein. Diese Intensitätsmodulatoren IM1, IM2, IM3, IM4 sind bekannt und in Silizium-Integrationsplattformen etabliert, dh sie können auf demselben Silizium-Chip integriert werden wie die Sendevorrichtung T1.

Die einzelnen Intensitätsmodulatoren IM1, IM2, IM3, IM4 haben jeweils einen elektronischen Steuereingang, über den die Abschwächung eingestellt werden kann, die das optische Signal erfährt, wenn es durch den jeweiligen Intensitätsmodulator IM1, IM2, IM3, IM4 gelangt. Die Intensitätsmodulatoren IM1, IM2, IM3, IM4 werden von einer gemeinsamen Steuereinheit Y angesteuert, die vorteilhafterweise in Silizium-Technologie gefertigt ist und ebenfalls auf demselben Silizium-Chip integriert ist, wie die Intensitätsmodulatoren IM1, IM2, IM3, IM4 und die Sendevorrichtung T1.

Die optischen Ausgänge der Intensitätsmodulatoren IM1, IM2, IM3, IM4 sind jeweils über die Wellenleiter WI1, WI2, WI3, WI4 unterschiedlichen Polarisationsfiltern FV, FH, FD, FA zugeführt, die jeweils für unterschiedlich polarisierte Anteile des optischen Signals durchlässig sind. Die Polarisationsfiltern FV, FH, FD, FA können ebenfalls auf bekannte Weise im selben Silizium-Chip integriert sein. Die optischen Ausgänge der Polarisationsfilter FV, FH, FD, FA werden über weitere Wellenleiter WV, WH, WD, WA an einen Mischer OM übertragen. Dieser ist wiederum auf dem Silizium-Chip integriert und leitet sämtliche bei ihm einlangenden optischen Signale an seinen optischen Ausgang über einen weiteren Wellenleiter W5 an einen optischen Abschwächer ATT weiter. Dieser optische Abschwächer ATT dient dazu, für quantenkryptographische Anwendungen ein Signal zu erzeugen, bei dem für einzelne Symbole Lichtmengen von wenigen Photonen verwendet werden. Gerade in diesem Anwendungsfall ist auch der Umstand, dass das von der Sendeeinheit T1 optischen Signale mit nur geringen Intensitäten ausgesandt werden, nicht von Bedeutung, da durch entsprechende Dimensionierung der Abschwächer ATT dasselbe Ergebnis erzielt werden kann wie mit bekannten laserbasierten Signalerzeugern. Die Schaltung wird hierdurch weiter vereinfacht. Der Ausgang des Abschwächers ATT bildet den optischen Ausgang des Chips, dh dieser wird zu einem externen optischen Wellenleiter-Anschluss OOpt weitergeleitet.

Optional kann die Schaltung auch ohne Abschwächer betrieben werden, da das optische Ausgangssignal auch durch Vorgabe eines entsprechend abgeschwächten elektrischen Eingangssignals auf eine vorgegebene Leistung abgeschwächt werden kann.

Die konkrete Signalform, dh die Abfolge von unterschiedlichen Polarisationsrichtungen der abgegebenen elektromagnetischen Wellen, wird im vorliegenden Fall durch die Steuereinheit Y vorgegeben. Dabei kann insbesondere vorgesehen sein, dass am Chip elektrische Eingänge IN vorgesehen sind, mit denen die Steuereinheit Y zur Abgabe von Signalen veranlasst werden kann. Ebenso sind am Chip elektrische Eingänge zur Spannungs- bzw. Leistungsversorgung der Sendevorrichtung T1 sowie der Intensitätsmodulatoren IM1, IM2, IM3, IM4 vorgesehen. Eine Ansteuerung der Intensitätsmodulatoren IM1, IM2, IM3, IM4 kann beispielsweise wie in **Fig. 4a** dargestellt erfolgen, indem die einzelnen Modulationseingänge der Intensitätsmodulatoren IM1, IM2, IM3, IM4 mit von der Steuereinheit erstellten Steuersignalen TXV, TXH, TXD, TXA angesteuert werden.

Im Chip ist auch ein optisches Netzwerk N vorhanden und integriert, das konkret die Sendevorrichtung T1, die optische Verteilereinheit OX Intensitätsmodulatoren IM1, IM2, IM3, IM4, die Polarisationsfiltern FV, FH, FD, FA, den Mischer OM und den Abschwächer ATT umfasst, wobei der optische Ausgang des Abschwächers ATT an den externen optischen Wellenleiter-Anschluss OOpt angeschlossen ist. Darüber hinaus sind im optisches Netzwerk N Wellenleiter WT, WI1, WI2, WI3, WI4, WV, WH, WD, WA, W5 zur Übertragung der einzelnen optischen Signale vorhanden, die allesamt im Chip integriert sind.

Eine alternatives Ausführungsbeispiel eines integrierten optoelektronischen Schaltkreises ist in **Fig. 5** näher dargestellt. Bei diesem sind mehrere Sendevorrichtungen TV, TH, TD, TA vorgesehen, deren Aufbau der Sendevorrichtung T1 entspricht. Diese sind, entsprechend dem in **Fig. 4** dargestellten Ausführungsbeispiel auf demselben Chip integriert. Ebenso ist eine Steuereinheit Y auf dem Chip integriert, die dazu ausgebildet ist, die einzelnen Sendevorrichtungen TV, TH, TD, TA bzw deren jeweilige Treiber DRV anzusteuern. Dabei kann beispielsweise vorgesehen sein, zum selben Zeitpunkt jeweils nur eine einzige Sendevorrichtung TV, TH, TD, TA anzusteuern. Ein Auswahlsignal, das die ausgewählte Sendevorrichtung TV, TH, TD, TA identifiziert, wird dem Chip als Sendesignal TXV, TXH, TXD, TXA zugeführt. Die Steuerschaltung Y erstellt dementsprechend einzelne Ansteuerungssignale für die Sendevorrichtungen TV, TH, TD, TA, wobei die jeweils ausgewählte Sendevorrichtung TV, TH, TD, TA ein optisches Signal an ihren Ausgang abgibt.

Die optischen Ausgänge der Sendevorrichtungen TV, TH, TD, TA sind jeweils über Wellenleiter W11, WI2, WI3, WI4 unterschiedlichen Polarisationsfiltern FV, FH, FD, FA zugeführt, die jeweils für unterschiedlich polarisierte Anteile des optischen Signals durchlässig sind. Die Polarisationsfilter FV, FH, FD, FA können ebenfalls auf bekannte Weise im selben Silizium-Chip integriert sein. Die optischen Ausgänge der Polarisationsfilter FV, FH, FD, FA werden über weitere Wellenleiter WV, WH, WD, WA an einen Mischer OM übertragen. Dieser ist wiederum auf dem Silizium-Chip integriert und leitet sämtliche bei ihm einlangenden optischen Signale an seinen optischen Ausgang über einen weiteren Wellenleiter W5 an einen optischen Abschwächer ATT weiter, dessen optischer Ausgang an den externen optischen Wellenleiter-Anschluss OOpt angeschlossen ist.

Bei allen dargestellten Ausführungsbeispielen ist es möglich, dass das zu erzeugende optische Signal durch ein elektrisches Signal festgelegt wird, das über einen elektronischen Dateneingang IN des Chips an die elektrische Steuereinheit Y weitergeleitet wird. Alternativ ist es aber auch möglich, dass die Steuereinheit Y ein Signal selbst nach einem vorgegebenen Muster erzeugt oder ein Zufallssignal erzeugt. Dieses der Erzeugung des optischen Signals zugrunde liegende und von der Steuereinheit Y erzeugte elektrische Signal kann, sofern es für weitere Zwecke benötigt wird, auch an einem elektrischen Ausgang des Chips zur Verfügung gehalten werden.

## Patentansprüche

1. Optoelektronische Sendevorrichtung (T1), umfassend
a) einen elektronischen Eingang (TX),
b) einen optischen Wellenleiter-Anschluss (O) zur Abgabe von optischen Signalen,
c) eine Diode (D) in Form einer wellenleitergebundenen Silizium-Germanium pin-Photodiode mit zwei Elektroden (A, K), wobei der der optische Wellenleiter-Anschluss (O) am photosensitiven Bereich der Diode (D) mündet, und
d) einen dem elektronischen Eingang (TX) nachgeschalteten Datentreiber (DRV), der dazu ausgebildet ist, am elektronischen Eingang (TX) anliegende elektronische Signale in Form von elektrischen Strom- und/oder Spannungssignalen an der Diode (D) anzulegen, sodass sich abhängig von dem am Dateneingang (TX) anliegenden Signal ein Stromfluss in Durchlassrichtung der Diode (D) ausbildet, sodass die Diode daraufhin über ihren photosensitiven Bereich elektromagnetische Wellen über den Wellenleiter-Anschluss (O) abgibt.

2. Optoelektronische Sende- und Empfangsvorrichtung (T2) umfassend:
a) einen optischen Wellenleiter-Anschluss (O), über welchen optische Signale bidirektional von und zu der optoelektronischen Sende- und Empfangsvorrichtung gelangen,
b) einen elektronischen Dateneingang (TX),
c) einen elektronischen Datenausgang (RX),
d) einen Steuereingang (S) zur Auswahl eines Betriebsmodus, an dem ein Steuersignal anliegt, das vorgibt, ob sich die Sende- und Empfangsvorrichtung (T2) im jeweiligen Zeitpunkt entweder
- in einem Sendemodus befindet und optischen Datensignale am optischen Wellenleiter-Anschluss (O) als am elektronischen Dateneingang (TX) anliegenden elektronischen Daten aussendet, oder
- in einem Empfangsmodus befindet und optische Datensignale über den optischen Wellenleiter-Anschluss (O) empfängt und in ein am Datenausgang (RX) anliegendes elektronisches Datensignal umwandelt,
e) eine Diode (D) in Form einer wellenleitergebundenen Silizium-Germanium pin-Photodiode mit zwei Elektroden (A, K), wobei der der optische Wellenleiter-Anschluss (O) am photosensitiven Bereich der Diode (D) mündet,
f) einen dem Steuereingang (S) und dem elektronischen Dateneingang (TX) nachgeschalteten Datentreiber (DRV), der an die Kathode (K) der Diode (D) angeschlossen ist und dazu ausgebildet ist,
- während des Sendemodus am elektronischen Dateneingang (TX) anliegende Signale in Form von elektrischen Spannungssignalen an der Diode (D) anzulegen, sodass sich abhängig von dem am Dateneingang anliegenden Signal ein Stromfluss in Durchlassrichtung der Diode (D) ausbildet,
und
- während des Empfangsmodus die Kathode (K) der Diode (D) auf einen vorgegebenen Spannungsniveau oder Arbeitspunkt vorzuspannen, sodass sich bei Vorliegen eines optischen Signals am photosensitiven Bereich der Diode (D) ein vom optischen Signal abhängiger Photostrom in Sperrrichtung der Diode (D) ausbildet,
g) einen Verstärker, insbesondere einen Transimpedanzverstärker, der an die Anode (A) der Diode (D) angeschlossen ist und dazu ausgebildet ist,
- während des Sendemodus die Anode (A) der Diode (D) auf einen vorgegebenen Spannungsniveau oder Arbeitspunkt vorzuspannen,
- während des Empfangsmodus, den durch die Diode (D) fließenden Diodenstrom zu messen, in ein elektrisches Signal umzuwandeln und derart am elektronischen Datenausgang (RX) zur Verfügung zu stellen.

3. Optoelektronischer integrierter silizium-basierter Schaltkreis (C) umfassend
- zumindest eine optoelektronische Sendevorrichtung (T1) nach Anspruch 1 und/oder optoelektronischen Sende- und Empfangsvorrichtung (T2) nach Anspruch 2, insbesondere eine Mehrzahl solcher Vorrichtungen (T1, T2), der oder die auf oder in demselben Trägermaterial integriert sind,
- eine elektrische Steuereinheit (Y) zum Ansteuern der zumindest einen optoelektronischen Sende und/oder Empfangsvorrichtungen (T1, T2), die im silizium-basierter Schaltkreis integriert ist,
- ein im selben Schaltkreis (C) integriertes optisches Netzwerk (N) umfassend zumindest einen externen optischen Wellenleiter-Anschluss (OOpt), und eine Anzahl von Wellenleitern, die an die optischen Wellenleiter-Anschlüsse der zumindest einen Sende- und/oder Empfangsvorrichtung (T1, T2) und an den zumindest einen externen optischen Wellenleiter-Anschluss (OOpt) angeschlossen sind.

4. Optoelektronischer Schaltkreis nach Anspruch 3 zur optischen Datenübertragung, umfassend
- wobei die Steuereinheit (Y) dazu ausgebildet ist, die optoelektronischen Sende- und/oder Empfangsvorrichtungen (T1, T2) und gegebenenfalls im optischen Netzwerk befindliche elektrooptische Bauelemente (B1, ...) derart anzusteuern, dass am Wellenleiter-Anschluss (O) das festgelegte abzugebende Signal anliegt.

5. Optoelektronischer Schaltkreis nach Anspruch 3 oder 4 umfassend zumindest einen elektronischen Dateneingang (IN), der an die elektrische Steuereinheit (Y) angeschlossen ist und zumindest ein vom Schaltkreis an seinem zumindest einen Wellenleiter-Anschluss (O) abzugebendes Signal festlegt.
